# EUROPÄISCHE PATENTSCHRIFT

(11) **EP 3 787 039 B1**
(45) Veröffentlichungstag und Bekanntmachung des Hinweises auf die Patenterteilung: **21.12.2022**
(21) Anmeldenummer: 20000289.7
(22) Anmeldetag: 17.08.2020
(51) Int. Cl.: H01L 31/0687, H01L 31/0224, H01L 31/0216

(54) **SCHUTZVERFAHREN FÜR DURCHGANGSÖFFNUNGEN EINER HALBLEITERSCHEIBE**
METHOD OF PROTECTING THROUGH HOLES OF A SEMICONDUCTOR WAFER
PROCÉDÉ DE PROTECTION POUR OUVERTURES DE PASSAGE DANS UNE PLAQUE SEMI-CONDUCTRICE

(30) Priorität: 29.08.2019 DE 102019006093
(43) Veröffentlichungstag der Anmeldung: 03.03.2021
(73) Patentinhaber: AZUR SPACE Solar Power GmbH, 74072 Heilbronn (DE)
(72) Erfinder: FREY, Alexander, 74081 Heilbronn (DE); HAGEDORN, Benjamin, 74248 Ellhofen (DE)
(74) Vertreter: Koch Müller Patentanwaltsgesellschaft mbH

(56) Entgegenhaltungen:
- EP-A2- 0 528 311
- EP-A2- 1 715 529
- WO-A1-89/05521
- US-A1- 2011 272 020
- US-A1- 2014 048 128
- US-A1- 2017 213 922
- US-B1- 9 680 035
- E.J. MITCHELL ET AL: "Epitaxy-Through-Holes Process for Epitaxy Wrap-Through Solar Cells", PROC. OF THE 24TH EUROPEAN PHOTOVOLTAIC SOLAR ENERGY CONFERENCE, 21. September 2009 (2009-09-21), - 24. September 2009 (2009-09-24), Seiten 2362-2365, XP040530372, ISBN: 978-3-936338-25-6

## Beschreibung

Die Erfindung betrifft ein Schutzverfahren für Durchgangsöffnungen einer Halbleiterscheibe.

Um die Abschattung der Vorderseite einer Solarzelle zu reduzieren, ist es möglich, sowohl die positive als auch die negative externe Kontaktfläche auf der Rückseite anzuordnen. Bei sogenannten Metal Wrap Through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Lochs bzw. einer Durchgangskontaktöffnung durch eine Solarzelle bekannt. Die durch die Durchgangsöffnung verlaufende Metallisierung wird mittels einer Isolationsschicht gegenüber den Schichten des Solarzellenstapels isoliert.

Beispielsweise ist aus der US 9,680,035 B1 ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt wird. Der Ätzprozess basiert darauf, dass sich die Ätzraten zumindest für die verwendeten unterschiedlichen III-V-Materialien des Solarzellenstapels nicht Wesentlich unterscheiden. Eine Passivierung und Metallisierung der Vorderseite und des Lochs wird vor dem Dünnen der Substratschicht durchgeführt.

Aus der US 2017/213922 A1, und der EP 0 528 311 A2, und der WO 89/05521 A1, und der EP 1 715 529 A2, und der US 2014/048128 A1, und der US 2011/272020 A1, und aus E. J. MITCHELL ET AL: "Epitaxy-Through-Holes Process for Epitaxy Wrap-Through Solar Cells" PROC. OF THE 24TH EUROPEAN PHOTOVOLTAIC SOLAR ENERGY CONFERENCE, 21. September 2009, - 24. September 2009, Seiten 2362-2365 sind weitere Verfahren und Vorrichtungen bekannt.

Wird die Passivierung, also eine Isolationsschicht, flächig auf die Vorderseite des Solarzellenstapels und die Seitenfläche der Durchgangskontaktöffnung aufgebracht, so muss die Durchgangskontaktöffnung vor dem anschließenden Strukturieren der Isolationsschicht auf der Vorderseite zuverlässig geschützt werden.

Es ist beispielsweise bekannt, Oberflächen, insbesondere mit Löchern, mittels einer Folie zu beschichten. Solche Folien werden beispielsweise von der Firma DuPont als DuPont Dry Film Resists angeboten und vertrieben z.B. durch micro resist technology GmbH, Berlin.

Vor diesem Hintergrund besteht die Aufgabe der Erfindung darin, eine Vorrichtung anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Schutzverfahren für Durchgangsöffnungen einer Halbleiterscheibe bereitgestellt, mindestens umfassend die Schritte:
- Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle und mindestens zwei III-V-Teilzellen in der genannten Reihenfolge sowie mindestens eine von der Oberseite bis zu der Unterseite der Halbleiterscheibe reichende Durchgangsöffnung mit zusammenhängender Seitenwand und einem im Querschnitt ovalen Umfang aufweist,
- flächiges Aufbringen einer dielektrischen Isolationsschicht auf die Oberseite der Halbleiterscheibe und die Seitenwand der Durchgangsöffnung und die Unterseite der Halbleiterscheibe, anschließend
- Aufbringen einer Fotolackschicht auf die Oberseite und zumindest einen sich an die Oberseite anschließenden Bereich der Seitenwand der Halbleiterscheibe,
- Aufbringen eines organischen Füllmaterials mittels eines Druckverfahrens auf einen die Durchgangsöffnung umfassenden Bereich der Oberseite und in die Durchgangsöffnung hinein, wobei die Schritte in der genannten Reihenfolge durchgeführt werden.

Es versteht sich, dass die Fotolackschicht belichtet und entwickelt wird. Vorzugsweise werden die beiden Schritte vor dem Aufbringen von weiteren Schichten durchgeführt.

Ein Vorteil ist, dass mittels des zusätzlichen Aufbringens des organischen Füllmaterials einen zuverlässigen Schutz der Isolationsschicht im Bereich der Durchgangsöffnung ausgebildet wird.

Durch das Aufbringen mittels eines Druckverfahrens, z.B. Siebdruck oder Inkjet oder Dispenser, ist der zeitliche und technische Aufwand für den zusätzlichen Prozessschritt gering.

Ein weiterer Vorteil ist, dass hiermit auf einfache und kostengünstige Weise eine sehr effiziente und zuverlässige Solarzelle herstellbar ist.

In einer ersten Ausführungsform wird die Fotolackschicht vor oder nach oder während des Aufbringens auf die Oberseite der Halbleiterscheibe zusätzlich auf die Unterseite der Halbleiterscheibe aufgebracht.

In einer Weiterbildung wird nach dem Aufbringen des Füllmaterials auf einen die Durchgangsöffnung umfassenden Bereich der Oberseite der Halbleiterscheibe zusätzlich mittels eines Druckverfahrens das Füllmaterial auf einen die Durchgangsöffnung umfassenden Teil der Unterseite der Halbleiterscheibe und in die Durchgangsöffnung aufgebracht wird.

Erfindungsgemäß wird vor dem Aufbringen der Fotolackschicht eine dielektrische Isolationsschicht auf die Oberseite der Halbleiterscheibe und die Seitenwand der Durchgangsöffnung und die Unterseite der Halbleiterscheibe flächig aufgebracht.

In einer Weiterbildung wird nach dem Aufbringen des organischen Füllmaterial die Fotolackschicht auf Teilbereichen der Oberseite und/oder der Unterseite der Halbleiterscheibe entfernt, werden durch das Entfernen der Fotolackschicht freigelegte Teile der dielektrischen Isolationsschicht entfernt und wird ein restlicher Teil der Fotolackschicht entfernt, wobei die genannten Schritte in der genannten Reihenfolge ausgeführt werden.

Gemäß einer weiteren Ausführungsform wird mittels des Druckverfahrens die Durchgangsöffnung zumindest bis zu einem von der Fotolackschicht gebildeten Boden mit dem Füllmaterial gefüllt und mit dem Füllmaterial ein über die Oberseite der Fotolackschicht hinausragende Erheben ausgebildet.

In einer anderen Ausführungsform ist das Druckverfahren ein Siebdruckverfahren oder ein Inkjet-Verfahren oder ein Dispens-Verfahren.

In einer weiteren Weiterbildung ist das Füllmaterial ein Lack oder ein Schmelzklebstoff.

In einer anderen Ausführungsform ist das Füllmaterial ein Wachs, ein Harz, ein Kleber oder ein Thermoplast.

In einer anderen Weiterbildung weist die Durchgangsöffnung der bereitgestellten Halbleiterscheibe an einem an die Oberseite der Halbleiterscheibe angrenzenden Rand einen ersten Durchmesser von höchstens 1 mm und mindestens 50 µm auf.

An einem an die Unterseite der Halbleiterscheibe angrenzenden Rand weist die Durchgangsöffnung einen zweiten Durchmesser von höchstens 1 mm und von mindestens 50 µm auf.

Vorzugsweise weist die bereitgestellte Halbleiterscheibe eine Gesamtdicke von höchstens 300 µm und von mindestens 90 µm auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: einen Ablauf gemäß einer ersten Ausführungsform eines erfindungsgemäßen Schutzverfahrens für Durchgangsöffnungen einer Halbleiterscheibe,
- Figur 2: einen Querschnitt einer mittels des erfindungsgemäßen Schutzverfahrens beschichteten Durchgangsöffnung einer Halbleiterscheibe.

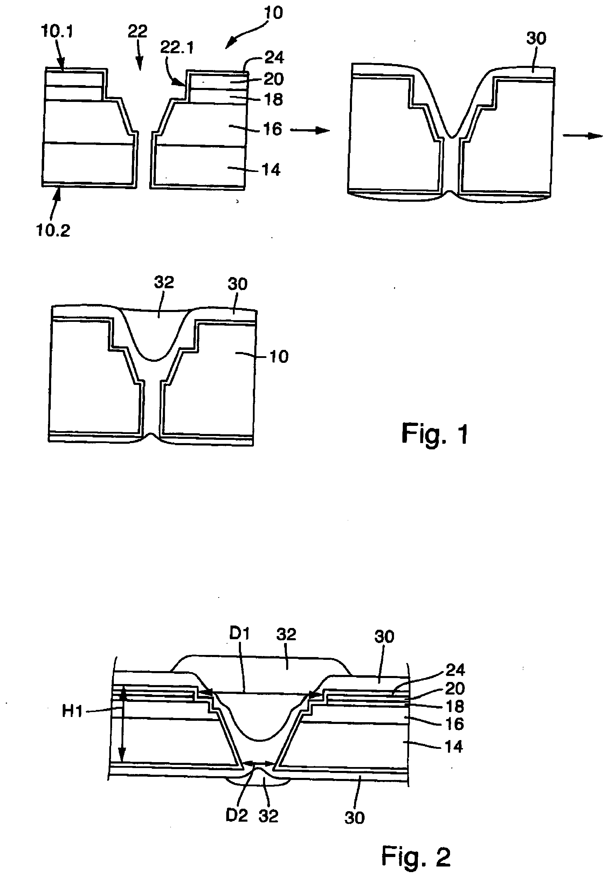

Die Abbildung der Figur 1 zeigt einen schematischen Ablauf eines Schutzverfahrens für Durchgangsöffnungen einer Halbleiterscheibe gemäß einer ersten erfindungsgemäßen Ausführungsform.

Es wird eine Halbleiterscheibe 10 mit einer Oberseite 10.1, einer Unterseite 10.2 und einer sicher von der Oberseite 10.1 bis zu der Unterseite 10.2 erstreckenden Durchgangsöffnung 22 mit einer zusammenhängenden Seitenwand 22.1 und einem im Querschnitt ovalen Umfang bereitgestellt.

Die Halbleiterscheibe 10 umfasst mehrere noch nicht vereinzelte Solarzellenstapel 12 jeweils mit einer Schichtfolge aus einem die Unterseite 10.2 ausbildenden Ge-Substrat 14, einer Ge-Teilzelle 16, einer ersten III-V-Teilzelle 18 und einer die Oberseite 10.1 ausbildenden zweiten III-V-Teilzelle 20. Die Oberseite 10.1, die Unterseite 10.2 sowie die Seitenwand 22.1 der Durchgangsöffnung ist mit einer dielektrischen Isolationsschicht 24 beschichtet.

Anschließend wird eine Fotolackschicht 30 auf die Oberseite 10.1 und die Unterseite 10.2 der Halbleiterscheibe 10 sowie auf die Seitenwand 22.1 der Durchgangsöffnung 22 aufgebracht, wobei die Fotolackschicht 30 typischerweise die Durchgangsöffnung zumindest teilweise füllt.

In einem weiteren Verfahrensschritt wird ein organisches Füllmaterial 32 mittels eines Druckverfahrens auf einen die Durchgangsöffnung 22 umfassenden Bereich der Oberseite 10.1 der Durchgangsöffnung 22 aufgebracht, wobei das Füllmaterial in dem dargestellten Ausführungsbeispiel die Durchgangsöffnung bis zu einem von der Fotolackschicht 30 ausgebildeten Boden füllt.

In der Abbildung der Figur 2 ist eine weitere Ausführungsform dargestellt. Im Folgenden werden nur die Unterschiede zu der Abbildung der Figur 1 erläutert.

In der dargestellten Ausführungsform bildet das aufgebrachte Füllmaterial 32 eine über die Fotolackschicht hinausragende Erhebung aus.

Zusätzlich wird in einem weiteren Verfahrensschritt das organische Füllmaterial 32 mittels des Druckverfahrens auf einen die Durchgangsöffnung 22 umfassenden Bereich der Unterseite 10.2 aufgebracht, wobei sich ebenfalls eine über die Fotolackschicht hinausragende Erhebung ausbildet.

Die Durchgangsöffnung 22 weist an der Oberseite 10.1 der Halbleiterscheibe einen ersten Durchmesser D1 und an der Unterseite 20.2 einen zweiten Durchmesser D2 auf, wobei der erste Durchmesser D1 größer als der zweite Durchmesser D1 ist.

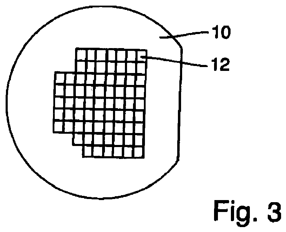

In der Abbildung der Figur 3 ist eine Aufsicht auf eine Halbleiterscheibe 10 mit mehreren Solarzellenstapeln 12 dargestellt. Gemäß einer erfindungsgemäßen Ausführungsform befindet sich im Bereich jedes Solarzellenstapels mindestens ein Loch, welches mittels des Schutzverfahrens beschichtet wird.

## Patentansprüche

1. Schutzverfahren für Durchgangsöffnungen (22) einer Halbleiterscheibe (10) mindestens umfassend die Schritte:
- Bereitstellen einer Halbleiterscheibe (10) mit einer Oberseite (10.1), einer Unterseite (10.2) und umfassend mehrere Solarzellenstapel (12),
- wobei jeder Solarzellenstapel (12) ein die Unterseite (10.1) der Halbleiterscheibe ausbildendes Ge-Substrat (14), eine Ge-Teilzelle (16) und mindestens zwei III-V-Teilzellen (18, 20) in der genannten Reihenfolge sowie mindestens eine von der Oberseite (10.1) bis zu der Unterseite (10.2) der Halbleiterscheibe (10) reichende Durchgangsöffnung (22) mit zusammenhängender Seitenwand (22.1) und einem im Querschnitt ovalen Umfang aufweist,
- **flächiges Aufbringen einer** dielektrischen **Isolationsschicht (24) auf die Oberseite (10.1) der Halbleiterscheibe (10) und die Seitenwand (22.1) der Durchgangsöffnung (22)** und **die Unterseite (10.2) der Halbleiterscheibe (10), anschließend**
- Aufbringen einer Fotolackschicht (30) auf die Oberseite (10.1) der Halbleiterscheibe (10) und zumindest einen sich an die Oberseite anschließenden Bereich der Seitenwand (22.1) der Durchgangsöffnung (22),
- Aufbringen eines organischen Füllmaterials (32) mittels eines Druckverfahrens auf einen die Durchgangsöffnung (22) umfassenden Bereich der Oberseite (10.1) und in die Durchgangsöffnung (22) hinein, wobei die Schritte in der genannten Reihenfolge durchgeführt werden.

2. Verfahren nach Anspruch 1, **dadurch gekennzeichnet, dass** die Fotolackschicht (30) vor oder nach oder während des Aufbringens auf die Oberseite (10.1) der Halbleiterschiebe (10) zusätzlich auf die Unterseite (10.2) der Halbleiterscheibe (10) aufgebracht wird.

3. Verfahren nach Anspruch 2, **dadurch gekennzeichnet, dass** nach dem Aufbringen des Füllmaterials (32) auf einen die Durchgangsöffnung (22) umfassenden Bereich der Oberseite (10.1) der Halbleiterscheibe (10) zusätzlich mittels eines Druckverfahrens das Füllmaterial (32) auf einen die Durchgangsöffnung (22) umfassenden Teil der Unterseite (10.2) der Halbleiterscheibe (10) und in die Durchgangsöffnung aufgebracht wird.

4. Verfahren nach Anspruch 1, **dadurch gekennzeichnet, dass**
- nach dem Aufbringen des organischen Füllmaterial (32) die Fotolackschicht (30) auf Teilbereichen der Oberseite (10.1) und/oder der Unterseite (10.2) der Halbleiterscheibe (10) entfernt wird,
- durch das Entfernen der Fotolackschicht (30) freigelegte Teile der dielektrischen Isolationsschicht (24) entfernt werden und
- ein restlicher Teil der Fotolackschicht (30) entfernt wird,
- wobei die genannten Schritte in der genannten Reihenfolge ausgeführt werden.

5. Verfahren nach einem der vorstehenden Ansprüche, **dadurch gekennzeichnet, dass** mittels des Druckverfahrens die Durchgangsöffnung (22) zumindest bis zu einem von der Fotolackschicht (30) gebildeten Boden mit dem Füllmaterial (32) gefüllt und mit dem Füllmaterial (32) ein über die Oberseite (10.1) der Fotolackschicht hinausragende Erheben ausgebildet wird.

6. Verfahren nach einem der vorstehenden Ansprüche, **dadurch gekennzeichnet, dass** das Druckverfahren ein Siebdruckverfahren oder ein Inkjet-Verfahren oder ein Dispens-Verfahren ist.

7. Verfahren nach einem der vorstehenden Ansprüche, **dadurch gekennzeichnet, dass** das Füllmaterial (32) ein Lack oder ein Schmelzklebstoff ist.

8. Verfahren nach einem der vorstehenden Ansprüche, **dadurch gekennzeichnet, dass** die Durchgangsöffnung (22) der bereitgestellten Halbleiterscheibe
- an einem an die Oberseite (10.1) der Halbleiterscheibe (10) angrenzenden Rand einen ersten Durchmesser (D1) von höchstens 1 mm und mindestens 50 µm aufweist und
- an einem an die Unterseite (10.2) der Halbleiterscheibe (10) angrenzenden Rand einen zweiten Durchmesser (D2) von höchstens 1 mm und von mindestens 50 µm aufweist, wobei
- die bereitgestellte Halbleiterscheibe (10) eine Gesamtdicke (H1) von höchstens 300 µm und von mindestens 90 µm aufweist.

## Claims

1. Method of protecting passage openings (22) of a semiconductor wafer (10), comprising at least the steps:
- providing a semiconductor wafer (10) with an upper side (10.1), a lower side (10.2) and comprising a plurality of solar cell stacks (12),
- wherein each solar cell stack (12) comprises a Ge substrate (14) forming the lower side (10.1) of the semiconductor wafer, a Ge part cell (16) and at least two III-V part cells (18, 20) in the stated sequence as well as at least one passage opening (22) which extends from the upper side (10.1) to the lower side (10.2) of the semiconductor wafer (10), with a continuous side wall (22.1) and a circumference oval in cross-section,
- application of a dielectric insulating layer (24) over an area on the upper side (10.1) of the semiconductor wafer (10) and the side wall (22.1) of the passage opening (22) and the lower side (10.2) of the semiconductor wafer (10), subsequently
- applying a photoresist layer (30) on the upper side (10.1) of the semiconductor wafer (10) and at least a region, which adjoins the upper side, of the side wall (22.1) of the passage opening (22),
- applying an organic filler material (32) by means of a printing method on a region, which surrounds the passage opening (22), of the upper side (10.1) and in the passage opening (22), wherein the steps are carried out in the stated sequence.

2. Method according to claim 1, **characterised in that** the photoresist layer (30) is additionally applied to the lower side (10.2) of the semiconductor wafer (10) prior to or after or during the application to the upper side (10.1) of the semiconductor wafer (10).

3. Method according to claim 2, **characterised in that** after application of the filler material (32) to a region, which surrounds the passage opening (22), of the upper side (10.1) of the semiconductor wafer (10) the filler material (32) is additionally applied by means of a printing method to a part, which surrounds the passage opening (22), of the lower side (10.2) of the semiconductor wafer (10) and in the passage opening.

4. Method according to claim 1, **characterised in that**
- after application of the organic filler material (32) the photoresist layer (30) on part regions of the upper side (10.1) and/or the lower side (10.2) of the semiconductor wafer (10) is removed,
- parts of dielectric insulating layer (24) are removed by the removal of the photoresist layer (30) and
- a residual part of the photoresist layer (30) is removed,
- wherein the stated steps are carried out in the stated sequence.

5. Method according to any one of the preceding claims, **characterised in that** by means of the printing method the passage opening (22) is filled at least up to a base, which is formed by the photoresist layer (30) with the filler material (32) and an elevation projecting above the upper side (10.1) of the photoresist layer is formed by the filler material.

6. Method according to any one of the preceding claims, **characterised in that** the printing method is a screen-printing method or an inkjet method or a dispensing method.

7. Method according to any one of the preceding claims, **characterised in that** the filler material (32) is a lacquer or a hot-melt adhesive.

8. Method according to any one of the preceding claims, **characterised in that** the passage opening (22) of the provided semiconductor wafer
- has a first diameter (D1) of at most 1 mm and at least 50 µm at an edge adjoining the upper side (10.1) of the semiconductor wafer (10) and
- a second diameter (D2) of at most 1 mm and at least 50 µm at an edge adjoining the lower side (10.2) of the semiconductor wafer (10), wherein
- the provided semiconductor wafer (10) has an overall thickness (H1) of at most 300 µm and at least 90 µm.

## Revendications

1. Procédé de protection pour des trous de passage (22) d'une plaquette de semi-conducteur (10) comprenant au moins les étapes suivantes :
- préparation d'une plaquette de semi-conducteur (10) avec une face supérieure (10.1) et une face inférieure (10.2) et comprenant plusieurs piles de cellules solaires (12),
- chaque pile de cellules solaires (12) présentant un substrat de Ge (14) constituant la face inférieure (10.1) de la plaquette de semi-conducteur, une sous-cellule de Ge (16) et au moins deux sous-cellules III-V (18, 20) dans l'ordre indiqué, ainsi qu'au moins un trou de passage (22) avec une paroi latérale cohérente (22.1) et une périphérie de section ovale allant de la face supérieure (10.1) à la face inférieure (10.2) de la plaquette de semi-conducteur (10),
- application à plat d'une couche d'isolation diélectrique (24) sur la face supérieure (10.1) de la plaquette de semi-conducteur (10), la paroi latérale (22.1) du trou de passage (22) et la face inférieure (10.2) de la plaquette de semi-conducteur (10), puis
- application d'une couche de vernis photosensible (30) sur la face supérieure (10.1) de la plaquette de semi-conducteur (10) et au moins une région de la paroi latérale (22.1) du trou de passage (22) contigüe à la face supérieure, et
- application d'un matériau de remplissage organique (32) au moyen d'un procédé d'impression sur une région de la face supérieure (10.1) entourant le trou de passage (22) et dans le trou de passage (22), ces étapes étant exécutées dans l'ordre mentionné.

2. Procédé selon la revendication 1, **caractérisé en ce que** la couche de vernis photosensible (30) est appliquée en outre sur la face inférieure (10.2) de la plaquette de semi-conducteur (10) avant ou après ou pendant l'application sur la face supérieure (10.1) de la plaquette de semi-conducteur (10).

3. Procédé selon la revendication 2, **caractérisé en ce qu'**après l'application du matériau de remplissage (32) sur une région de la face supérieure (10.1) de la plaquette de semi-conducteur (10) entourant le trou de passage (22), le matériau de remplissage (32) est en outre appliqué au moyen d'un procédé d'impression sur une partie de la face inférieure (10.2) de la plaquette de semi-conducteur (10) entourant le trou de passage (22).

4. Procédé selon la revendication 2, **caractérisé en ce que**
- la couche de vernis photosensible (30) sur les régions partielles de la face supérieure (10.1) et/ou la face inférieure (10.2) de la plaquette de semi-conducteur (10) est enlevée après l'application du matériau de remplissage organique (32),
- les parties de la couche d'isolation diélectrique (24) libérées par l'élimination de la couche de vernis photosensible (30) sont enlevées et
- une partie restante de la couche photosensible (30) est enlevée,
- les étapes indiquées étant exécutées dans l'ordre mentionné.

5. Procédé selon une des revendications précédentes, **caractérisé en ce qu'**au moyen du procédé d'impression, le trou de passage (22) est rempli de matériau de remplissage (32) au moins jusqu'à un fond formé par la couche de vernis photosensible (30) et qu'une élévation dépassant la face supérieure (10.1) de la couche de vernis photosensible est constituée par le matériau de remplissage (32).

6. Procédé selon une des revendications précédentes, **caractérisé en ce que** la procédé d'impression est un procédé de sérigraphie ou un procédé à jet d'encre ou un procédé d'application.

7. Procédé selon une des revendications précédentes, **caractérisé en ce que** le matériau de remplissage (32) est un vernis ou une colle thermofusible.

8. Procédé selon une des revendications précédentes, **caractérisé en ce que** le trou de passage (22) de la plaquette de semi-conducteur préparée
- présente au niveau d'un bord délimitant la face supérieure (10.1) de la plaquette de semi-conducteur (10) un premier diamètre (D1) de 1 mm maximum et 50 µm minimum et
- présente au niveau d'un bord délimitant la face inférieure (10.2) de la plaquette de semi-conducteur (10) un deuxième diamètre (D2) de 1 mm maximum et 50 µm minimum,
- la plaquette de semi-conducteur préparée (10) présentant une épaisseur totale (H1) de 300 µm maximum et 90 µm minimum.
